# EUROPEAN PATENT SPECIFICATION

(11) **EP 4 166 561 B1**
(45) Date of publication and mention of the grant of the patent: **18.06.2025**
(21) Application number: 21821007.8
(22) Date of filing: 10.06.2021
(51) Int. Cl.: C09K 11/06, C07F 15/00, H10K 85/30, H10K 101/10

(54) **QUADRIDENTATE RING METAL PLATINUM (II) COMPLEX BASED ON CARBOXYL COORDINATION AND COMPRISING PYRIDYL ACRIDINE AND USE THEREOF**
VIERZACKIGER RINGMETALL-PLATIN(II)-KOMPLEX AUF CARBOXYLKOORDINATIONSBASIS, DER PYRIDYLACRIDIN UMFASST, UND VERWENDUNG DAVON
COMPLEXE MÉTAL PLATINE (II) À CYCLE QUADRIDENTÉ À BASE DE COORDINATION CARBOXYLE ET COMPRENANT DE LA PYRIDYL ACRIDINE ET SON UTILISATION

(30) Priority: 10.06.2020 CN 202010522102
(43) Date of publication of application: 19.04.2023
(73) Proprietor: Zhe Jiang University of Technology, Hangzhou, Zhejiang 310014 (CN); Zhejiang Huaxian Photoelectricity Technology Co., Ltd, Jiaxing, Zhejiang 314107 (CN)
(72) Inventor: LI, Gui Jie, Hangzhou, Zhejiang 310014 (CN); SHEN, Gang, Hangzhou, Zhejiang 310014 (CN); SHE, Yuanbin, Hangzhou, Zhejiang 310014 (CN); ZHOU, Chun Song, Hangzhou, Zhejiang 310014 (CN)
(74) Representative: Schweiger, Martin
(86) International application number: PCT/CN2021/099496
(87) International publication number: WO 2021/249507

(56) References cited:
- CN-A- 111 518 142
- US-A1- 2006 210 831
- US-A1- 2008 001 530
- LI GUIJIE, SHEN GANG, FANG XIAOLI, YANG YUN-FANG, ZHAN FENG, ZHENG JIANBING, LOU WEIWEI, ZHANG QISHENG, SHE YUANBIN: "Phosphorescent Tetradentate Platinum(II) Complexes Containing Fused 6/5/5 or 6/5/6 Metallocycles", INORGANIC CHEMISTRY, vol. 59, no. 24, 21 December 2020 (2020-12-21), pages 18109 - 18121, XP055878727, ISSN: 0020-1669, DOI: 10.1021/acs.inorgchem.0c02569
- ZHAO DANLI, HUANG CHEN-CHAO, LIU XIANG-YANG, SONG BO, DING LEI, FUNG MAN-KEUNG, FAN JIAN: "Efficient OLEDs with Saturated Yellow and Red Emission Based on Rigid Tetradentate Pt(II) Complexes", ORGANIC ELECTRONICS, vol. 62, 1 November 2018 (2018-11-01), pages 542 - 547, XP055878732, ISSN: 1566-1199, DOI: 10.1016/j.orgel.2018.06.028
- LIU GUOJUN, LIANG FENG, ZHAO YUE, HU HAILIANG, FAN JIAN, LIAO LIANG-SHENG: "Phosphorescent Platinum(II) Complexes Based on Spiro Linkage-Containing Ligands", JOURNAL OF MATERIALS CHEMISTRY C, vol. 5, no. 8, 16 January 2017 (2017-01-16), GB, XP055878735, ISSN: 2050-7526, DOI: 10.1039/C6TC04312G
- LI GUIJIE, ZHAN FENG, ZHENG JIANBING, YANG YUN-FANG, WANG QUNMIN, CHEN QIDONG, SHEN GANG, SHE YUANBIN: "Highly Efficient Phosphorescent Tetradentate Platinum(II) Complexes Containing Fused 6/5/6 Metallocycles", INORGANIC CHEMISTRY, vol. 59, no. 6, 16 March 2020 (2020-03-16), pages 3718 - 3729, XP055878738, ISSN: 0020-1669, DOI: 10.1021/acs.inorgchem.9b03376

## Description

### TECHNICAL FIELD

The present invention relates to the technical field of organic light-emitting materials, and in particular, to a tetradentate cyclometalated platinum (II) coordination complex based on carboxyl coordination and containing pyridyl acridine, and use thereof.

### BACKGROUND

An organic light-emitting diode (OLED) is an autonomous light-emitting device without a backlight. It has the advantages of fast response, low power consumption, high light-emission efficiency, high contrast, simple production process, and mass production. Early devices mainly adopt organic small-molecule fluorescent materials as light-emitting materials. However, the spin-statistics quantum theory indicates that the theoretical internal quantum efficiency of fluorescent materials is only 25%. In 1998, Professor Forrest of Princeton University discovered the phenomenon of phosphorescence electroluminescence of metal organic coordination complex molecular materials at room temperature, and the strong spin-orbit coupling of heavy metal atoms can effectively promote the intersystem crossing of electrons from singlet to triplet, so that OLED devices can make full use of electrical excitation to generate all singlet and triplet excitons, leading to the theoretical internal quantum efficiency of the light-emitting materials of up to 100% *(*Nature, 1998, 395, 151).

Most of cyclometalated platinum (II) coordination complex phosphorescent materials studied in the early stage are metal-organic molecules containing bidentate and tridentate ligands. Due to the low rigidity, bidentate ligands are easy to twist and vibrate, resulting in low phosphorescence quantum efficiency *(*Inorg. Chem. 2002, 41, 3055). Cyclometalated platinum (II) coordination complexes containing tridentate ligands have decreases in electrochemical, photochemical, and thermal stability due to a second ligand (such as Cl⁻, phenoxy anion, alkyne anion, and carbene) required in the molecule. Therefore, both bidentate and tridentate cyclometalated platinum (II) coordination complex phosphorescent materials are not suitable for production of stable and efficient OLED devices, especially difficult to meet the requirements of commercial phosphorescent materials. Based on the above, how to design and develop stable and efficient phosphorescent materials is still the key to the field of OLED.

Tetradentate ligands for platinum (II) are also known, such as from Guijie Li et al., Inorg. Chem., 2020, 59, 3718-3729.

### SUMMARY

An objective of the present invention is to provide a tetradentate cyclometalated platinum (II) coordination complex based on carboxyl coordination and containing pyridyl acridine, and use thereof, to resolve the problem of low quantum efficiency of existing phosphorescent materials. The coordination complex is characterized by high quantum efficiency and adequate stability, and therefore can be used as a light-emitting material for OLED devices.

To achieve the foregoing objective, the present invention adopts the following technical solutions:
According to a first aspect, an embodiment of the present invention provides a tetradentate cyclometalated platinum (II) coordination complex based on carboxyl coordination and containing pyridyl acridine, where the tetradentate cyclometalated platinum (II) coordination complex has the structure of the general formula (I): 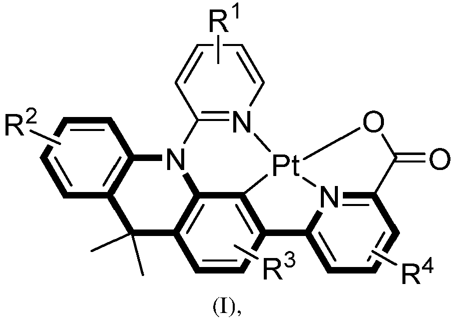 wherein each of R¹, R², R³, and R⁴ independently represents mono-, di-, tri-, tetra-substitution, or no substitution, and R¹, R², R³, and R⁴ are each independently hydrogen, deuterium, alkyl, aryl, cycloalkyl, heterocyclyl, heteroaryl, or a combination thereof; and two or more adjacent R¹, R², R³, and R⁴ are each independently or selectively linked to form a fused ring.

According to a second aspect, an embodiment of the present invention also provides an organic light-emitting element, including a substrate and a light-emitting layer including the tetradentate cyclometalated platinum (II) coordination complex according to the first aspect on the substrate.

According to the foregoing technical solutions, the coordination complex includes a tetradentate ligand containing a strong-field ligand of an oxygen negative ion, with strong coordination capability and high rigidity, which can improve the quantum efficiency and photostability, and therefore can be used as a light-emitting material for OLED devices.

### BRIEF DESCRIPTION OF THE DRAWINGS

To describe the technical solutions of the embodiments of the present invention more clearly, the following briefly introduces the accompanying drawings required for describing the embodiments:
FIG. 1 shows an emission spectrum of the platinum coordination complex Pt1 in a DCM solution at room temperature, an emission spectrum of the platinum coordination complex Pt1 in PMMA at room temperature, and an emission spectrum of the platinum coordination complex Pt1 in 2-MeTHF at 77 K according to an embodiment of the present invention (DCM is dichloromethane, PMMA is poly(methyl methacrylate), and 2-MeTHF is 2-methyltetrahydrofuran).
FIG. 2 shows high resolution of the platinum coordination complex Pt1 according to an embodiment of the present invention.
FIG. 3 shows the test of photostability of platinum coordination complex Pt1-doped polystyrene film under the excitation of UV light at 375 nm with a light intensity of 500 W/m².
FIG. 4 shows the test of photostability of polystyrene films doped with platinum coordination complexes Pt(bp-2), Pt(bp-3), Pt(bp-4), and Pt(bp-5) under the excitation of UV light at 375 nm with a light intensity of 500 W/m².
FIG. 5 is a schematic structural diagram of a light-emitting element in this example.

### DETAILED DESCRIPTION

The compound of the present invention may contain "optionally substituted" moieties. Generally, the term "substituted" (whether or not it is preceded by the term "optionally") means that one or more hydrogens of the indicated moiety are replaced by a proper substituent. Unless otherwise specified, an "optionally substituted" group may have a proper substituent at each substitutable position of the group, and when more than one substituent selected from a given group may be substituted at more than one positions in any given structure, the substituents at the positions may be the same or different. Substituent combinations contemplated by the present invention are preferably those that form stable or chemically feasible compounds. According to some aspects, unless expressly indicated to the contrary, it is also contemplated that each substituent may be further optionally substituted (that is, further substituted or unsubstituted).

The structure of the compound may be represented by the following formula:

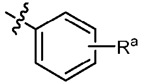

It is understood to be equivalent to the following formula: 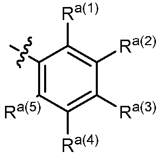 m is usually an integer. That is, (R^{a})ₘ is understood to represent five independent substituents R^{a(1)}, R^{a(2)}, R^{a(3)}, R^{a(4)}, and R^{a(5)}.

The following example provides a method for preparing a novel compound, but the preparation of the compound is not limited to this method. In this professional technical field, since the compound protected in this patent is easy to be modified and prepared, the compound may be prepared by the method listed below or by other methods. The following example is only used as an embodiment, and is not intended to limit the protection scope of this patent. The temperature, catalyst, concentration, reactant, and reaction procedure are all variable to prepare the compound for different reactants.

The ¹H NMR (500 MHz) spectrum is determined by the ANANCEIII (500 MHz) NMR spectrometer. Unless otherwise specified, for NMR, DMSO-*d₆* or 0.1% TMS in CDCl₃ is used as a solvent. For ¹H NMR, if CDCl₃ is used as a solvent, TMS (δ = 0.00 ppm) is used as an internal reference; if DMSO-*d₆* is used as a solvent, TMS (δ = 0.00 ppm) or residual DMSO peak (δ = 2.50 ppm) or residual water peak (δ = 3.33 ppm) is used as an internal reference. In the data of the ¹H NMR spectrum: s = singlet; d = doublet; t = triplet; q = quartet; p = quintet; m = multiplet; and br = broad.

The example of synthesizing the tetradentate cyclometalated platinum (II) coordination complex based on carboxyl coordination and containing pyridyl acridine is described as follows:
The preparation may be carried out with reference to the following synthesis method:

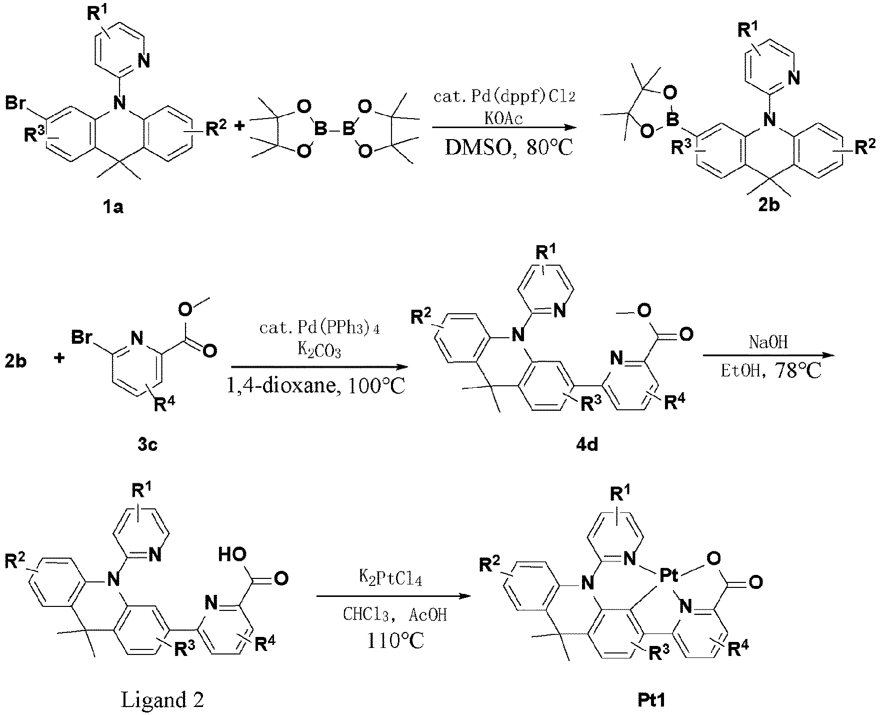

It can be understood that the foregoing method does not limit a certain product. Each of R¹, R², R³, and R⁴ independently represents mono-, di-, tri-, tetra-substitution, or no substitution, and R¹, R², R³, and R⁴ are each independently hydrogen, deuterium, alkyl, aryl, cycloalkyl, heterocyclyl, heteroaryl, or a combination thereof; and two or more adjacent R¹, R², R³, and R⁴ are each independently or selectively linked to form a fused ring. The feeding order and specific reaction conditions are not limited, such as temperature, type and consumption of solvent, type and consumption of catalyst, type and consumption of ligand, type and consumption of alkali, and consumption of reaction substrate. A person skilled in the art may easily obtain proper extension from the example in the embodiments of the present invention. Other groups are defined in accordance with the general formula (I).

Example 1: A platinum coordination complex **Pt1** may be synthesized according to the following route:

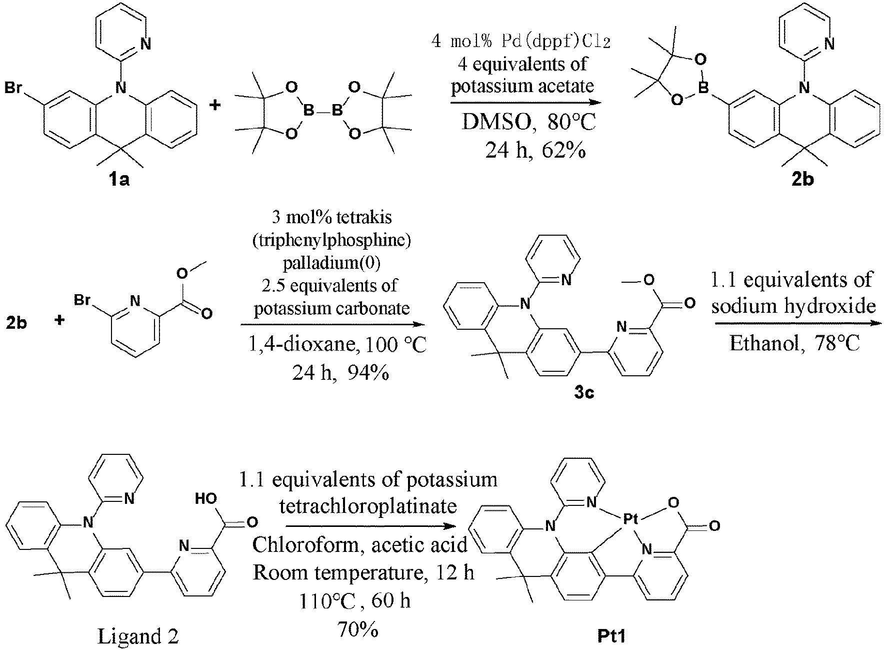

Synthesis of intermediate 2b: An intermediate 1a (1.50 g, 4.11 mmol, 1.00 equivalent), bis(pinacolato)diboron (1.57 g, 6.17 mmol, 1.50 equivalents), [1,1'-bis(diphenylphosphino)ferrocene]palladium(II) dichloride (120 mg, 0.16 mmol, 0.04 equivalents), and potassium acetate (1.61 g, 16.44 mmol, 4.00 equivalents) were added sequentially in a dry three-neck flask with a magnetic stirring rotor, purged with nitrogen for three times, and DMSO (25 mL) was added in a nitrogen atmosphere, to obtain a mixture. The mixture was stirred in an oil bath pot at 80°C to react for 24 h, cooled down to room temperature, and extracted with ethyl acetate, to obtain an organic layer and an aqueous layer. The organic layer was washed with water twice, and the aqueous layer was extracted with ethyl acetate twice. The obtained organic phases were combined, dried with anhydrous sodium sulfate, filtered, and distilled under reduced pressure to remove the solvent, to obtain a crude product. The crude product was separated and purified by silica gel chromatography with an eluant:6etroleum ether/ethyl acetate = 20:1-5:1, to obtain 898 mg of white solid as a product 2b with a yield of 56%. ¹H NMR (500 MHz, CDCl₃): δ 1.28 (s, 12H), δ1.62 (s, 6H), 7.01-7.05 (m, 2H), 7.10 (td, *J =* 8.0, 1.5 Hz, 1H), 7.17 (ddd, *J* = 7.0, 4.5, 0.5 Hz, 1H), 7.28 (d, *J =* 8.5 Hz, 1H), 7.39 (s, 1H), 7.43 (dd, *J =* 8.0, 1.5 Hz, 1H), 7.46 (d, *J =* 8.0 Hz, 1H), 7.50 (dd, *J* = 7.5, 1.0 Hz, 1H), 7.76 (td, *J =* 8.0, 2.0 Hz, 1H), 8.62 (dd, *J =* 5.0, 1.5 Hz, 1H).

Synthesis of intermediate 3c: The intermediate 2b (0.68 g, 1.65 mmol, 1.00 equivalent), 6-bromopyridine-2-carboxylic acid methylester (0.39 g, 1.80 mmol, 1.10 equivalents), tetrakis(triphenylphosphine)palladium(0) (57 mg, 0.05 mmol, 0.03 equivalents), and potassium carbonate (570 mg, 4.13 mmol, 2.50 equivalents) were added sequentially in a dry three-neck flask with a magnetic stirring rotor, purged with nitrogen for three times, and 1,4-dioxane (30 mL) was added in a nitrogen atmosphere, to obtain a mixture. The mixture was stirred in an oil bath pot at 100°C to react for 24 h, cooled down to room temperature, and distilled under reduced pressure to remove the solvent, to obtain a crude product. The crude product was separated and purified by silica gel chromatography with an eluant: petroleum ether/ethyl acetate = 10:1-3:1, to obtain 0.58 g of yellow solid as a product 3c with a yield of 83%. ¹H NMR (500 MHz, DMSO-*d₆*): δ1.69 (s, 6H), 4.00 (s, 3H), 6.82 (dd, *J =* 8.0, 1.0 Hz, 1H), 7.05 (td, *J* =7.5, 1.5 Hz, 1H), 7.08-7.12 (m, 1H), 7.2-7.31 (m, 1H), 7.38 (dt, *J* =8.0, 1.0 Hz, 1H), 7.48-7.50 (m, 2H), 7.58 (d, *J =* 8.5 Hz, 1H), 7.71-7.73 (m, 2H), 7.83 (t, *J* = 2.5 Hz, 1H), 7.87-7.88 (m, 1H), 8.00 (dd, *J* = 7.5, 1.0 Hz, 1H), 8.72-8.74 (m, 1H).

Synthesis of ligand 2: The intermediate 3c (0.64 g, 1.55 mmol, 1.00 equivalent) and sodium hydroxide (2.48 g, 6.20 mmol, 1.10 equivalents) were added sequentially in a dry three-neck flask with a magnetic stirring rotor, purged with nitrogen for three times, and ethanol (30 mL) was added in a nitrogen atmosphere, to obtain a mixture. The mixture was stirred in an oil bath pot at 78°C to react for 2 h, cooled down to room temperature, and distilled under reduced pressure to remove the solvent, to obtain a crude product. The crude product was separated and purified by silica gel chromatography with eluants: petroleum ether/ethyl acetate = 3:1 and ethyl acetate/methanol = 10:1, to obtain 0.58 g of brownish yellow solid as a ligand 2 with a yield of 92%. ¹H NMR (500 MHz, DMSO-*d₆*): δ 1.64 (s, 6H), 6.65(dd, *J* = 8.0, 1.5 Hz, 1H), 7.05 (td, *J* = 7.5, 1.0 Hz, 1H), 7.10 (td, *J* = 8.0, 2.0 Hz, 1H), 7.42(d, *J =* 2.0 Hz, 1H), 7.43-7.46 (m, 2H), 7.54 (dd, *J* = 7.5, 1.5 Hz, 1H), 7.65 (d, *J =* 8.5 Hz, 1H), 7.78 (dd, *J =* 8.5, 2.0 Hz, 1H), 7.90-7.94 (m, 2H), 8.00 (t, *J =* 7.5 Hz, 1H), 8.03 (td, *J =* 8.0, 2.0 Hz, 1H), 8.69 (dd, *J =* 5.0, 2.0 Hz, 1H).

Synthesis of Pt1: The ligand 2 (300 mg, 0.74 mmol, 1.0 equivalent) and potassium tetrachloroplatinate (336 mg, 0.81 mmol, 1.10 equivalents) were added sequentially in a dry three-neck flask with a magnetic stirring rotor, purged with nitrogen for three times, and chloroform (4 mL) and acetic acid (40 mL) were added in a nitrogen atmosphere, to obtain a mixture. The mixture was stirred at room temperature for 12 h and then stirred in an oil bath pot at 110°C to react for 60 h, cooled down to room temperature, and distilled under reduced pressure to remove the solvent, to obtain a crude product. The crude product was separated and purified by silica gel chromatography with eluants: petroleum ether/dichloromethane = 2:1 and dichloromethane/ethyl acetate/methanol = 10:10:1, to obtain 309 mg of yellow solid as a product Pt1 with a yield of 70%. ¹H NMR (500 MHz, DMSO-*d₆*): δ 1.36 (s, 3H), δ1.90 (s, 3H), 7.21-7.26 (m, 2H), 7.27-7.30 (m, 3H), 7.57 (dd, *J =* 7.5, 1.5 Hz, 1H), 7.63 (d, *J =* 8.0 Hz, 2H), 7.67 (dd, *J =* 7, 1.5 Hz, 1H), 8.04-8.08 (m, 1H), 8.10-8.14 (m, 2H), 8.87 (dd, *J =* 6.0, 1.5 Hz, 1H).

Examples of performance evaluation of metal Pt(II) coordination complex:
The following photophysical analysis was carried out on the coordination complex prepared in the foregoing example of the present invention:
Photophysical analysis: The emission spectrum and excited-state lifetime were all tested on the HORIBA FL3-11 spectrometer. Test condition: A solid-state solution of the light-emitting material in 2-methyltetrahydrofuran was tested for the emission spectrum and excited-state lifetime at low temperature; a solution of the light-emitting material in dichloromethane (DCM) was tested for the emission spectrum and excited-state lifetime at room temperature; and a doping concentration of a poly(methyl methacrylate) (PMMA) film sample was 5%.

The data of the photophysical properties of the tetradentate platinum coordination complex Pt1 phosphorescent material is shown in the following table 1:

**Table 1: List of the data of the photophysical properties of the tetradentate platinum coordination complex Pt1 phosphorescent material**

| Coordination complex | Emission spectrum at 77 K (2-MeTHF solution) | | Emission spectrum at room temperature (DCM solution) | | | Emission spectrum at room temperature (PMMA film) | | |
|---|---|---|---|---|---|---|---|---|
| | *λ*ₘₐₓ [nm] | *τ* [µs] | *λ*ₘₐₓ [nm] | *τ* [µs] | *Φ*_{PL} [%] | *λ*ₘₐₓ [nm] | *τ* [µs] | *Φ*_{PL} [%] |
| Pt1 | 508 | 7.81 | 516 | 6.39 | 99 | 516 | 5.25 | 68 |

| | | | | | | | | |
|---|---|---|---|---|---|---|---|---|
| Note: DCM is dichloromethane; 2-MeTHF is 2-methyltetrahydrofuran; PMMA is poly(methyl methacrylate); *λ* is the wavelength; *λ*ₘₐₓ is the maximum wavelength; *τ* is the excited-state lifetime of the material; and *Φ*_{PL} is the phosphorescence quantum efficiency. | | | | | | | | |

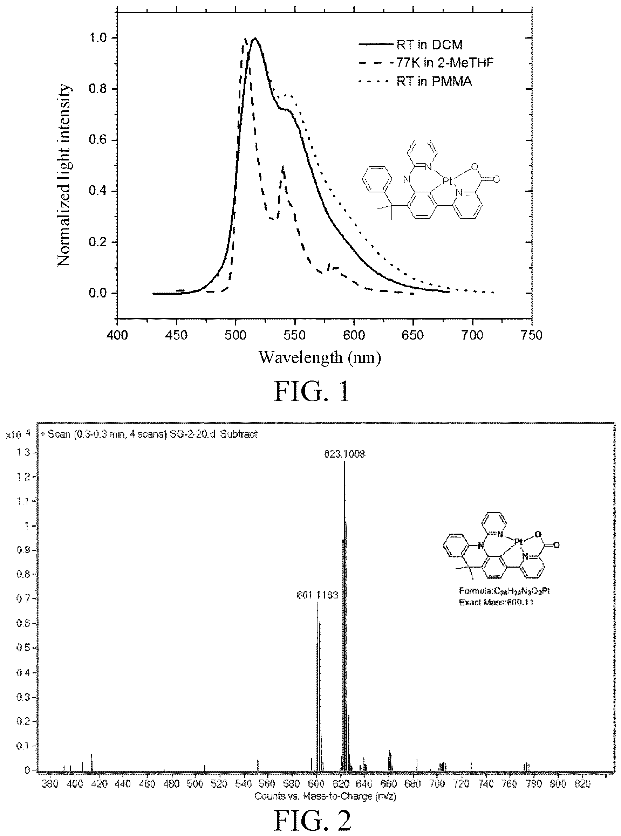

It can be learned from the data in the table 1 that: first, the quantum efficiency of the material in the DCM solution can reach 99%, and the quantum efficiency of the material in the PMMA film can reach 68%, indicating that the platinum coordination complex is high and stable in quantum efficiency, which can be used as an excellent phosphorescent material for OLED devices; second, the platinum coordination complex Pt1 phosphorescent material has many emission wavelengths in different environments in the green light range, which is a very good green light-emitting material; third, the platinum coordination complex Pt1 phosphorescent material has a short excited-state lifetime (*τ*) less than 10 µs in the 2-MeTHF solution or the DCM solution or the PMMA film at room temperature, especially the excited-state lifetime in the PMMA film approaches 5 µs, a short excited-state lifetime is beneficial to the improvement of the response speed of OLED devices with Pt1 as the light-emitting material, and is also beneficial to the improvement of its phosphorescence efficiency for the manufacture of the devices; and fourth, the platinum coordination complex Pt1 phosphorescent material has a small shift in maximum emission wavelength (*λ*ₘₐₓ) in different environments and conditions; it can be learned from FIG. 1 that, in the comparison of emission spectrum among 2-MeTHF at low temperature (77 K), DCM at room temperature, and PMMA at room temperature, the platinum coordination complex Pt1 phosphorescent material has a small shift in *λ*ₘₐₓ, indicating that such material has high luminescence photochromatic stability.

**Table 2: High resolution of coordination complex Pt1**

| Molecular formula | Molecular ion peak | m/z | Calc m/z | Diff (ppm) |
|---|---|---|---|---|
| C26 H19 N3 O2 [195Pt] | C26 H19 N3 Na O2 [195Pt] | 623.1008 | 623.1017 | 1.54 |

It can be verified from FIG. 2 and hydrogen spectrum that the structure of the platinum coordination complex Pt1 is correct.

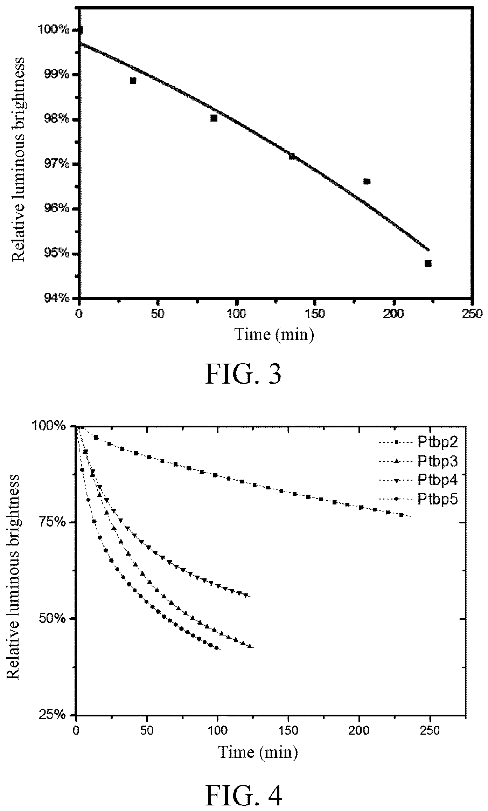

To examine the stability of the developed material, the photostability of 5 wt% Pt1-doped polystyrene film was tested with an excitation light source of UV light at 375 nm and a light intensity of 500 W/m². The data of photostability is shown in FIG. 3. In addition, in comparison with Pt1, the photostabilities of cyclometalated platinum (II) coordination complexes Pt(bp-2), Pt(bp-3), Pt(bp-4), and Pt(bp-5) with structures shown as follows reported in the literature (Inorganic Chemistry, 2020, 59, 3718.) were also tested in the same condition as Pt1.

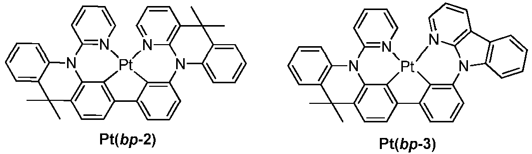

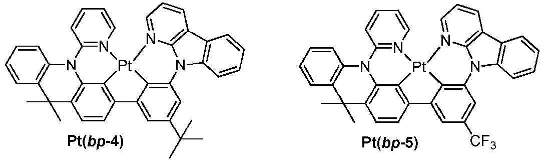

It can be learned from FIG. 3 that the phosphorescent material of 5 wt% Pt1-doped polystyrene film has an excellent photostability under the excitation of UV light at 375 nm (light intensity: 500 W/m²), and it takes about 225 minutes to decay by 5%.

It can be learned by comparing FIG. 3 with FIG. 4 that, in the photostability test, under the same conditions, Pt1 decays by 5% at 225 minutes; while Pt(bp-2) decays by 20% at 225 minutes, and Pt(bp-3), Pt(bp-4), and Pt(bp-5) all decay by more than 50% at 225 minutes. It can be learned that the phosphorescent material Pt1 containing the tetradentate cyclometalated platinum (II) coordination complex based on carboxyl coordination and containing pyridyl acridine developed in this application has a photostability much higher than the tetradentate metal Pt(II) coordination complexes coordinated by nitrogen atoms in the foregoing literature.

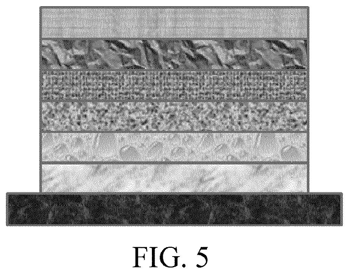

The present invention provides use of the tetradentate cyclometalated platinum (II) phosphorescent material in a light-emitting layer of organic electroluminescent devices. In an organic light-emitting element, carriers are injected into the light-emitting material from the positive and negative electrodes to generate an excited state and emit light. The complex represented by the general formula (I) in the present invention can be used as a phosphorescent material to be applied to excellent organic light-emitting elements such as organic photoluminescent elements or organic electroluminescent elements. The organic photoluminescent element has a structure in which at least a light-emitting layer is formed on a substrate. The organic electroluminescent element has a structure in which at least an anode, a cathode, and an organic layer between the anode and the cathode are formed. The organic layer includes at least a light-emitting layer. It may consist of only the light-emitting layer, or may consist of one or more organic layers in addition to the light-emitting layer. For example, the one or more organic layers may include a hole transport layer, a hole injection layer, an electron blocking layer, a hole blocking layer, an electron injection layer, an electron transport layer, an exciton blocking layer, and the like. The hole transport layer may be a hole injection transport layer with a hole injection function. The electron transport layer may be an electron injection transport layer with an electron injection function. The specific structure of the organic light-emitting element is shown in FIG. 5. In FIG. 5, there are seven layers from bottom to top, representing a substrate, an anode, a hole injection layer, a hole transport layer, a light-emitting layer, an electron transport layer, and a cathode, where the light-emitting layer is a mixed layer in which a guest material is doped into a host material.

The complex represented in Example 1 is used as a phosphorescent material to be applied to OLED devices, with a structure represented as:
ITO/HATCN (10 nm)/TAPC (65 nm)/CBP : complex represented in Example 1 (10-20 wt%, 20 nm)/Bepp₂ (10 nm)/Li₂CO₃ : Bepp₂ (5%, 30 nm)/Li₂CO₃ (1 nm)/Al (100 nm)

ITO is a transparent anode, HATCN is a hole injection layer, TAPC is a hole transport layer, CBP is a host material, the complex represented in Example 1 (10-20 wt% representing a doping concentration, and 20 nm representing a thickness of the light-emitting layer) is a guest material, Bepp₂ is an electron transport layer, Li₂CO₃ is an electron injection layer, and Al is a cathode. Numbers in nanometers (nm) in parentheses are the thickness of the films.

It is to be noted that the structure is an example of an application of the light-emitting material of the present invention, and does not constitute a limitation of the specific OLED device structure including the light-emitting layer of the present invention, and the phosphorescent material is not limited to the complex represented in Example 1.

The molecular formulas of the materials applied to devices are as follows:

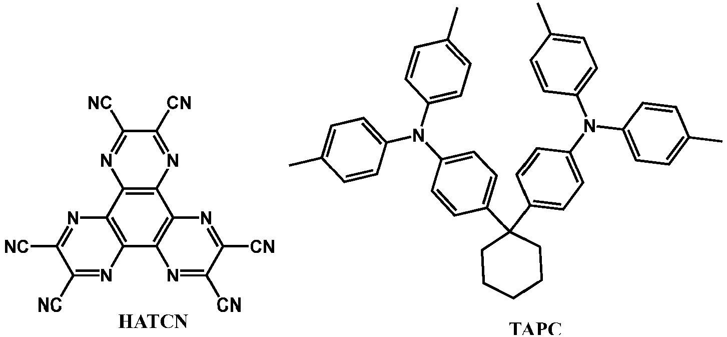

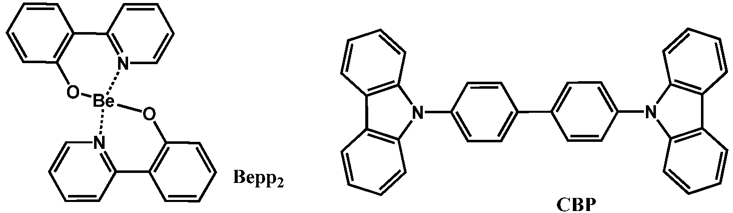

## Claims

1. A tetradentate cyclometalated platinum (II) coordination complex based on carboxyl coordination and containing pyridyl acridine, wherein the tetradentate cyclometalated platinum (II) coordination complex has the structure of the general formula (I): 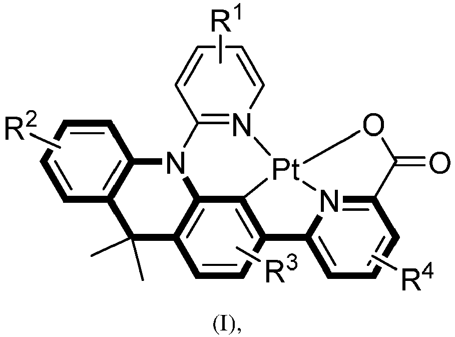 wherein each of R¹, R², R³, and R⁴ independently represents mono-, di-, tri-, tetra-substitution, or no substitution, and R¹, R², R³, and R⁴ are each independently hydrogen, deuterium, alkyl, aryl, cycloalkyl, heterocyclyl, heteroaryl, or a combination thereof; and two or more adjacent R¹, R², R³, and R⁴ are each independently or selectively linked to form a fused ring.

2. An organic light-emitting element, comprising a substrate and a light-emitting layer comprising the tetradentate cyclometalated platinum (II) coordination complex according to claim 1 on the substrate.

## Patentansprüche

1. Tetradentater cyclometallierter Platin(II)-Koordinationskomplex basierend auf Carboxylkoordination und enthaltend Pyridylacridin, wobei der tetradentate cyclometallierte Platin(II)-Koordinationskomplex die Struktur der allgemeinen Formel (I) aufweist: 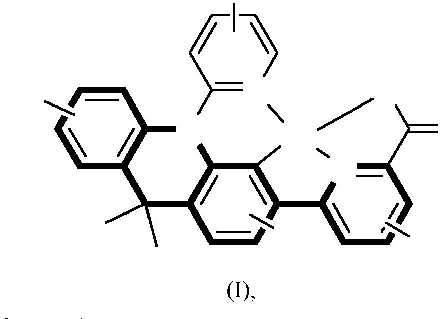 wobei R¹, R², R³ und R⁴ jeweils unabhängig voneinander eine Mono-, Di-, Tri-, Tetra-Substitution oder keine Substitution darstellen und R¹, R², R³ und R⁴ jeweils unabhängig voneinander Wasserstoff, Deuterium, Alkyl, Aryl, Cycloalkyl, Heterocyclyl, Heteroaryl oder eine Kombination davon sind; und zwei oder mehr benachbarte R¹, R², R³ und R⁴ jeweils unabhängig voneinander oder selektiv verbunden sind, um einen kondensierten Ring zu bilden.

2. Organisches lichtemittierendes Element, umfassend ein Substrat und eine lichtemittierende Schicht, umfassend den tetradentaten cyclometallierten Platin(II)-Koordinationskomplex gemäß Anspruch 1 auf dem Substrat.

## Revendications

1. Complexe de coordination cyclométallé tétradentate de platine(II) à base de coordination carboxyle et comprenant une acridine pyridylée, dans lequel le complexe de coordination cyclométallé tétradentate de platine (II) a la structure de la formule générale (I) : 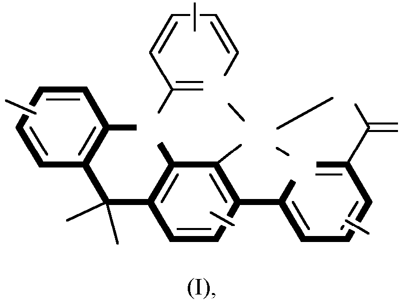 dans lequel chacun des R¹, R², R³ et R⁴ représente indépendamment une mono-, di-, tri-, tétra-substitution ou aucune substitution, et R¹, R², R³ et R⁴ sont chacun indépendamment un hydrogène, un deutérium, un alkyle, un aryle, un cycloalkyle, un hétérocyclyle, un hétéroaryle ou une combinaison de ceux-ci ; et deux ou plusieurs R¹, R², R³ et R⁴ adjacents sont chacun indépendamment ou sélectivement liés pour former un anneau fusionné.

2. Elément organique émetteur de lumière, comprenant un substrat et une couche émettrice de lumière comprenant le complexe de coordination cyclométallé tétradentate de platine(II) selon la revendication 1 sur le substrat.
